# EUROPÄISCHE PATENTANMELDUNG

(11) **EP 1 134 798 A1**
(43) Veröffentlichungstag der Anmeldung: **19.09.2001**
(21) Anmeldenummer: 00105501.1
(22) Anmeldetag: 15.03.2000
(51) Int. Cl.: H01L 21/336

(54) **Halbleiter-Bauelement, Verfahren zu seiner Herstellung und Verfahren zur Herstellung von elektrischen Verbindungen in bzw. auf einem Halbleiter-Substrat**

(71) Anmelder: Infineon Technologies AG, 81669 München (DE)
(72) Erfinder: Lachner, Rudolf, Dr., 85051 Ingolstadt (DE); Cappellani, Annalisa, Dr., 01099 Dresden (DE)
(74) Vertreter: Ginzel, Christian

(57) **Zusammenfassung**

Die Erfindung betrifft ein Verfahren zur Herstellung eines auf einem Halbleiter-Substrat (1) ausgebildeten integrierten Bauelements mit wenigstens einem gegenüber der Hauptoberfläche (11) des Substrats aufragend ausgebildeten Elektrodenanschluss (21), wobei direkt auf dem Halbleiter-Substrat (1) eine Elektroden-Substrat-Kontaktierung (81) aufgewachsen wird, wobei die Elektroden-Substrat-Kontaktierung (81) in elektrisch leitendem Kontakt mit dem zweiten Elektrodenanschluss (21) steht. Weiterhin betrifft die Erfindung ein Verfahren zur Herstellung von elektrischen Verbindungen (101, 102, 103, 10) zwischen einzelnen auf bzw. in einem Halbleiter-Substrat (1) ausgebildeten Schaltungselementen (21, 22, 23, LDD1, LDD2, 81, 82), wobei Leiterbahnkanäle (2a, 2b, 2c) in die planarisierte Fläche (111) aus Schaltungselementen und Füllmaterial (21, 22, 23, 81, 82, 71 bis 74, 6a) hinein gefertigt werden und mit einem gut leitenden Material (10) aufgefüllt werden. Ferner betrifft die Erfindung ein Halbleiterbauelement mit einem Substrat und einem Elektrodenanschluss (21), der elektrisch mit dem Substrat (1) verbunden ist.

## Beschreibung

Die Erfindung bezieht sich auf ein Verfahren zur Herstellung eines auf einem Halbleiter-Substrat ausgebildeten integrierten Bauelements mit wenigstens einem gegenüber der Hauptoberfläche des Substrats aufragend ausgebildeten Elektrodenanschluss, auf ein Verfahren zur Herstellung von elektrischen Verbindungen zwischen einzelnen auf bzw. in einem Halbleiter-Substrat ausgebildeten Schaltungselementen und auf ein Halbleiterbauelement mit einem Substrat und einem Elektrodenanschluss, der elektrisch mit dem Substrat verbunden ist.

Damit Transistoren, insbesondere Feldeffekttransistoren, auch in einem sehr hohen Frequenzbereich, namentlich einige Gigahertz, arbeiten können, müssen sie sehr niedrige parasitäre Kapazitäten und Impedanzen aufweisen, da diese die Leistungsfähigkeit und Brauchbarkeit des gesamten Transistors begrenzen. So begrenzen die parasitären Kapazitäten und Impedanzen insbesondere die Schaltgeschwindigkeit und die maximale Oszillationsfrequenz und Verschlechtern das Rauschverhalten. Kommt ein Transistor innerhalb einer integrierten elektronischen Schaltung auf bzw. in einem Halbleiter-Substrat zum Einsatz, so spielt auch das die einzelnen Komponenten der Schaltung verbindende Leitungssystem eine große Rolle bei der Schaltgeschwindigkeit der Schaltung und ein möglichst geringer Widerstand des Leitungssystems ist für eine hohe Leistungsausbeute und damit auch für eine Geschwindigkeitserhöhung notwendig.

Durch die bloße Reduzierung der Dimensionen der bisher bekannten Transistor-Strukturen, beispielsweise Reduktion der Gate-Länge eines Feldeffekttransistors auf etwa 100 Nanometer, wird der Widerstand durch lithografische und physikalische Effekte ("narrow line effects") drastisch erhöht, insbesondere sofern man herkömmliche Silizidierung von Gate-Elektroden zur Kontaktierung derselben heranzieht, da hier das wenige Material noch weiter reduziert wird. Bei einer Verkleinerung der herkömmlichen Strukturen, insbesondere der Gate-Längen und den damit zusammenhängenden weiteren Dimensionen geht auch die Notwendigkeit der Reduzierung der vertikalen Dimensionierung der Strukturen einher, um Kurzkanaleffekte ("short channel effects") in Grenzen zu halten. Die Kontaktierung derart flacher Elektrodenanschlüsse benötigt zudem einen enormen technischen Aufwand in der Strukturierung. Durch die Silizidation wird zudem ein beträchtlicher Teil der hoch dotierten Regionen der flachen Elektrodenanschlüsse verbraucht, wodurch die Funktionalität und die physikalischen Parameter negativ beeinflusst werden. Namentlich werden auch hier wieder die Kontaktwiderstände erheblich erhöht. Bewegt man sich in Dimensionierungsgrößen unterhalb eines Mikrons, so stellen die Kurzkanaleffekte als Brücken oder Durchschlagszonen und die Verringerung der Transistorelektronen ("hot electrons") die größten Hindernisse dar. Ein Mittel diesem zu begegnen, ist die Substratdotierung zu erhöhen, was wiederum in einer Erhöhung der Anschluss-Kapazität einen nachteiligen Effekt erzielt.

Die parasitären Kapazitäten werden durch die räumliche Nähe zwischen den einzelnen Elektroden erheblich erhöht.

Für die Erzielung derart kleiner Strukturen ist eine technisch sehr aufwendige und sehr teuere Lithografie notwendig, um die kleinen Strukturen realisieren zu können.

Aus der JP-A 07-324 749 ist ein Halbleiter-Bauelement und ein Verfahren zu seiner Herstellung bekannt geworden, bei dem eine Hilfsstruktur zur Anwendung kommt, die als Isolierungsschicht zur Reduktion der Anschluss-Kapazität dient. Allerdings ist bei dieser Vorgehensweise keine Reduktion der parasitären Kapazitäten zwischen den einzelnen Elektroden möglich und so ist folglich auch nicht aufgezeigt, wie dem Problem der hohen Widerstände der Elektrodenanschlüsse begegnet werden kann, Sorge getragen.

Vorbekannte Strukturen zeichnen sich dadurch aus, dass sie eine Vielzahl einzelner Herstellungsschritte benötigen, wobei eine zeit- und kostensparende gleichzeitige Herstellung aller Elektrodenanschlüsse und der elektrischen Verbindungen zwischen den einzelnen Schaltungselementen nicht ermöglicht wird.

Aus Widmann et al., "Technologie hochintegrierter Schaltungen", 2. Auflage, Springer Verlag ist ein Feldeffekttransistor vorbekannt, bei dem noch die übliche Technik des Feldoxids zur Isolierung verwendet wird, bei dem zur Herstellung der Leiter- und Kontaktschicht zusätzliche Masken und Verfahrensschritte notwendig sind.

Nach Alvares, "BiCMOS TECHNOLOGY AND APPLICATIONS", Kluwer Academic Publishers, ISBN 0-7923-9033-4 ist die Verwendung einer Titan-Nitridschicht zur lokalen Verdrahtung beschrieben. Jedoch sind auch hier zur Erstellung der lokalen Verdrahtung aufwendige Fotoentwicklungs- und Prozess-Schritte notwendig, wobei sich die relativ hochohmigen Schichten der Titan-Nitridschichten (15 Ohm/Square) nachteilig auswirken.

Somit sind der Anwendbarkeit der herkömmlichen Halbleitertechnik im SHF-Bereich, insbesondere im Bereich mehrerer Gigahertz, dadurch Grenzen gesetzt, dass durch die herkömmliche Technik der Herstellung von Elektrodenkontakten und elektrischen Verbindungen innerhalb der integrierten Schaltung durch die parasitären Kapazitäten und durch die technologiebedingten ohmschen Widerstände der Leitungen und Kontakte begrenzt.

So stellt sich das Hauptproblem in der Herstellung ultraschmaler Kontakte, da die herkömmlichen lithografischen Verfahren hier versagen.

Aufgabe der Erfindung ist es ein integriertes Bauelement und ein Verfahren zu seiner Herstellung zur Verfügung zu stellen, das die oben genannten Nachteile vermeidet und unter Einsparung von Maskenschritten beim Herstellungsprozess insbesondere die Ausbeute bei der Produktion erhöht und die Produktionskosten hierdurch und durch die Zeitersparnis verringert. Weiterhin ist es die Aufgabe der Erfindung ein Herstellungsverfahren für elektrische Verbindungen zwischen einzelnen auf bzw. in einem Halbleiter-Substrat ausgebildeten Schaltungselementen zur Verfügung zu stellen, das die hierfür notwendigen Prozessschritte auf ein Minimum reduziert, wobei die Leitfähigkeit der elektrischen Verbindungen maximiert ist.

Die Lösung dieser Aufgabe erfolgt verfahrensmäßig mit den kennzeichnenden Merkmalen des Anspruchs 1 und 27 und vorrichtungsmäßig mit den kennzeichnenden Merkmalen des Anspruchs 31.

Erfindungsgemäß ist vorgesehen, dass ein auf einem Halbleiter-Substrat ausgebildetes integriertes Bauelement mit wenigstens einem gegenüber der Hauptoberfläche des Substrats aufragend ausgebildeten Elektrodenanschluss vermittels der folgenden Verfahrensschritte hergestellt wird:
- Ausbilden einer Isolationsschicht auf der Hauptoberfläche des Halbleiter-Substrats,
- Ausbilden des erhöhten, gegenüber der Hauptoberfläche aufragenden Elektrodenanschlusses auf der Isolationsschicht,
- Fertigen einer das Halbleiter-Substrat freilegenden Ausnehmung in der Isolationsschicht durch wenigstens teilweises Entfernen der Isolationsschicht, wobei die Ausnehmung an der Seitenfläche des Elektrodenanschlusses abschließt, und
- Aufwachsen einer Elektroden-Substrat-Kontaktierung direkt auf dem Halbleiter-Substrat in der Ausnehmung der Isolationsschicht, wobei die Elektroden-Substrat-Kontaktierung in elektrisch leitendem Kontakt mit dem zweiten Elektrodenanschluss steht.

Die Erfindung schlägt vor, nach dem Ausbilden der vollständigen vom Substrat isolierten Elektrodenanschlusses die Kontaktierung desselben mit dem Substrat vermittels einer direkt auf dem Halbleitersubstrat aufgewachsenen Elektroden-Substrat-Kontaktierung. Der Vorteil dieser Vorgehensweise liegt darin, dass nicht Elektrodenteile zur Kontaktierung mit dem Substrat vorgesehen sind, sondern kleinere Strukturen als kleinstmöglich herstellbare Elektroden zur tatsächlichen Kontaktierung in den Ausnehmungen hergestellt werden können. Durch das erfindungsgemäße Vorgehen können bei der Herstellung solcher mit dem Substrat elektrisch verbundener Elektroden Masken (Retikel) und Ätz- bzw. Strukturierungsschritte eingespart werden.

Vorteilhafterweise wird die Elektroden-Substrat-Kontaktierung monolithisch oder polykristallin aufgewachsen. Hierdurch können selbst sehr kleine Ausnehmungen in der Isolationsschicht zur Kontaktierung des Substrat mit dem Elektrodenanschluss genutzt werden. Durch das erfindungsgemäße Verfahren wird die selbstjustierende bzw. selbsteinstellende ("self-aligned") Strukturierung von der tatsächlichen Substratkontaktierung ermöglicht. Hierdurch werden zum einen kostspielige Masken und Strukturierungsschritte eingespart und zum anderen kleinere Strukturen, als die durch die Belichtungstechnik kleinstmöglichen Strukturen herstellbar.

Die Ausbildung des erhöhten, gegenüber der Hauptoberfläche aufragenden Elektrodenanschlusses auf der Isolationsschicht, und/oder der Ausnehmung in der Isolationsschicht kann hierbei vorteilhafterweise unter Zuhilfenahme einer Maske durch Herausätzen von Teilen der Elektrodenanschlussschicht und der Isolationsschicht durch einen Strukturierungsschritt erfolgen, bei dem anisotropes Ätzen Anwendung findet.

Ein weiterer sehr vorteilhafter Verfahrensschritt sieht vor, dass vor der Herstellung der Elektroden-Substrat-Kontaktierung auf dem Halbleiter-Substrat ein unterhalb der Ausnehmung und/oder der nachher herzustellenden Elektroden-Substrat-Kontaktierung und innerhalb des Halbleiter-Substrats liegender dotierter Bereich ausgebildet wird. Dem folgend wird der dotierte Bereich durch eine Diffusion eines Dotierungsmaterials aus oder durch die Isolationsschicht in das Halbleiter-Substrat hinein hergestellt.

Ein weiterer ebenfalls sehr vorteilhafter und daher bevorzugter Verfahrensschritt sieht vor, dass nach der Herstellung der Elektroden-Substrat-Kontaktierung auf dem Halbleiter-Substrat ein unterhalb der Elektroden-Substrat-Kontaktierung und innerhalb des Halbleiter-Substrats, insbesondere innerhalb des dotierten Bereichs liegender dotierter Kontakt-Bereich ausgebildet wird. Dem folgend wird der dotierte Kotakt-Bereich durch eine Diffusion eines im Material der Elektroden-Substrat-Kontaktierung enthaltenen oder in dieses nachträglich eindiffundiertes Dotierungsmaterial in das Halbleiter-Substrat hinein hergestellt wird. Hierdurch kann durch einen Temperierungsschritt die Dotierung zur Herstellung der Kontakt-Bereichs zu einem wählbaren Zeitpunkt der Herstellung des integrierten Bauelements erfolgen.

Gemäß eines weiteren vorteilhaften Verfahrensschritts werden wenigstens ein erster und ein zweiter Elektrodenanschluss auf der Isolationsschicht hergestellt und die Ausnehmung wird in der Isolationsschicht zwischen den beiden Elektrodenanschlüssen hergestellt. Hierdurch kann vorteilhafterweise mit einfachen Schritten eine sehr kleine Diode strukturiert werden.

Die Elektroden-Substrat-Kontaktierung wird nach einem bevorzugten Verfahrensschritt so aufgewachsen, dass sie nur in elektrischem Kontakt mit dem ersten Elektrodenanschluss steht. Hierzu wird vorteilhafterweise vor dem Aufwachsen der Elektroden-Substrat-Kontaktierung eine Seitenisolierungsschicht an der dem ersten Elektrodenanschluss zugewandten Seitenfläche des zweiten Elektrodenanschlusses zur Vermeidung eines elektrischen Kontakts bzw. einer elektrischen Verbindung zwischen der Elektroden-Substrat-Kontaktierung und des zweiten Elektrodenanschlusses ausbildet.

Vorteilhafterweise werden die mehreren Elektrodenanschlüsse gleichzeitig hergestellt. Hierdurch können weitere teure Maskenschritte mit eingespart werden.

Weiterhin vorteilhafterweise werden zwischen jeweils zwei der Elektrodenanschlüsse jeweils eine Ausnehmung in der Isolationsschicht und jeweils ein dotierter Bereich unter jeweils einer Elektroden-Substrat-Kontaktierung im Halbleiter-Substrat hergestellt.

Bevorzugterweise werden wenigstens drei erhöhte, gegenüber der Hauptoberfläche aufragende Elektrodenanschlüsse auf der Isolationsschicht ausbildet und ebenso bevorzugterweise als integriertes Bauelement ein Feldeffekttransistor hergestellt. Erfindungsgemäß kann so ein Feldeffekttransistor unter gleichzeitiger Herstellung der Gate- Source- und Drain-Elektrodenanschlüsse bzw. der Elektroden-Substrat-Kontaktierung(en) gefertigt werden. Einer der Vorteile dieser Vorgehensweise ist, dass hierdurch gleich hohe Elektrodenanschlüsse bzw. Elektroden-Substrat-Kontaktierung(en) ohne großen Aufwand in einem Prozessschritt herstellbar sind. Das erfindungsgemäße Verfahren zur Herstellung eines Feldeffekttransistors eröffnet die mehrfache Anwendung der sogenannten selbstjustierenden Strukturierung. Hierdurch können sehr kleine Strukturen geschaffen werden, die in der sonst üblichen Fertigungsweise vermittels Belichtungs- und Ätz-Schritten nicht herstellbar wären. Durch die eröffnete Kleinheit der integrierten Bauelemente sind höhere Frequenzen schaltbar und die parasitären Parameter minimiert.

Bevorzugterweise ist die gegenüber der Hauptoberfläche des Halbleiter-Substrats horizontale Ausdehnung der Elektroden-Substrat-Kontaktierung kleiner als die gegenüber der Hauptoberfläche des Halbleiter-Substrats horizontale Ausdehnung des Elektrodenanschlusses.

Vorteilhafterweise werden die Elektrodenanschlüsse gleichzeitig durch Herausätzen von Bereichen und/oder der Ausnehmungen aus einer auf der Isolationsschicht bzw. auf der Isolationsdeckschicht aufgebrachten Elektrodenanschluss-Schicht hergestellt. Hierdurch sind die Ausnehmungen in der Isolationsschicht und/oder die Abstände der Elektrodenanschlüsse kleiner herstellbar als wenn die Elektrodenanschlüsse einzeln in verschiedenen Prozessschritten hergestellt werden.

Bevorzugterweise Weise wird das Herausätzen in einem anisotropen Ätzprozess vorgenommen. Hierdurch wird ein Unterätzen von Masken und/oder Strukturen verhindert, wodurch die gewünschte Kleinheit der Abstände der Elektrodenanschlüsse ermöglicht wird.

Weiterhin bevorzugt ist die Herstellung der Elektroden-Substrat-Kontaktierung so, dass ihre gegenüber dem Halbleiter-Substrat vertikale Ausdehnung unter der gegenüber dem Halbleiter-Substrat vertikalen Ausdehnung des Elektrodenanschlusses liegt. Hierdurch werden die parasitären Kapazitäten zwischen benachbarten Elektrodenanschlüssen möglichst klein gehalten.

Nach einem weiteren sehr vorteilhaften und daher bevorzugten Verfahrensschritt ist wenigstens einer der Elektrodenanschlüsse teilweise über einer in dem Halbleiter-Substrat ausgebildeten flachen Grabenisolation ("shallow-trench isolation") ausgebildet.

Eine Auffüllung wird nach einem weiteren vorteilhaften Verfahrensschritt auf dem Substrat bzw. der Isolationsschicht oder der Elektroden-Substrat-Kontaktierung aufgebracht, wobei sie die Seitenflächen bzw. die Seitenflächenisolationsschichten wenigstens eines Elektrodenanschlusses bedeckt. Hierdurch wird die Struktur aus Substrat, Isolationsschicht, Isolationsdeckschicht, Elektrodenanschlüssen und Elektroden-Substrat-Kontaktierungen planarisiert.

Vorteilhafterweise wird wenigstens einer der Elektrodenanschlüsse bis zu einer vorbestimmten Höhe abgetragen und ebenso vorteilhafterweise die sich durch das Abtragen des Elektrodenanschlusses zwischen den vormals diesen angrenzenden Auffüllungen und/oder den Seitenflächenisolationsschichten gebildete Vertiefung mit einer Leiterschicht aus einem gut leitenden Material ausgefüllt. Durch das erfindungsgemäße Vorgehen wird die selbstjustierende bzw. selbsteinstellende ("self-aligned") Strukturierung der Leiterschicht ermöglicht. Hierdurch werden kostspielige und zeitaufwendige Masken und Strukturierungsschritte eingespart.

Ein weiterer vorteilhafter Verfahrensschritt sieht vor, dass nach dem Auffüllen der Vertiefung mit dem gut leitenden Material durch eine Temperierung eine Silizidierung des gut leitenden Materials mit dem darunter liegendem Elektrodenanschluss und/oder der Elektroden-Substrat-Kontaktierung hergestellt wird. Hierdurch wird eine bessere Kontaktierung der Leiterschicht mit dem Elektrodenanschluss gewährleistet.

Vor dem Ausfüllen mit dem gut leitenden Material werden die die Vertiefung bildende, von der Hauptoberfläche des Substrats abgewandte Seitenfläche des Elektrodenanschlusses und/oder die der Vertiefung zugewandten Seitenflächen der Elektroden-Substrat-Kontaktierung und/oder die der Vertiefung zugewandten Seitenflächen der Auffüllung oder der Seitenflächenisolationsschichten nach einem weiteren vorteilhaften Verfahrensschritt mit einer Kontaktschicht bedeckt. Hierdurch wird wiederum eine bessere Kontaktierung der Leiterschicht mit dem Elektrodenanschluss gewährleistet.

Ein sehr vorteilhafter und daher besonders bevorzugter Verfahrensschritt sieht vor, dass die Auffüllung mit dem gut leitenden Material eine Leiterbahnschicht ("local interconnect system") bildet, mit der einzelne integrierte auf bzw. in dem Halbleiter-Substrat ausgebildete Bauelemente miteinander verbunden werden. Hierdurch wird die Herstellung von elektrischen Verbindungen zwischen einzelnen Bauelementen auf kontengünstigem und verfahrenstechnisch einfachem Weg ermöglicht.

Eine Polierung der Oberfläche der auf dem Substrat ausgebildeten integrierten Bauelemente und der Auffüllungen erfolgt nach einem weiteren Verfahrensschritt vermittels eines chemisch-mechanischen Polierprozesses. Dem folgend wird für den chemisch-mechanischen Polierprozesses ein Wasserstoffperoxyd enthaltendendes Schleif/Poliermittel verwendet. Vorteilhaft hierbei ist vor allem, dass keine Verunreinigungen in Form von Atomen bzw. Elementen vorliegen, wie etwa bei dem standardmäßig verwendeten Eisennitrat Fe(NO₃)₃, dessen Eisenionen unerwünschte Rekombinationszentren im Substrat bilden. Ein weiterer Vorteil der Polierung liegt in der Eröffnung der Möglichkeit weitere Schichten aufzubringen und mit voller Auflösung zu Strukturieren, da keine Unebenheiten vorliegen, und Multilayerstrukturen zu schaffen.

Ein weiterer bevorzugter Verfahrensschritt sieht vor, dass für die Auffüllungen Oxid und/oder Bor-Phosphor-Silikatglas verwendet wird.

Nach einem vorteilhaften Schritt des Verfahrens ist vorgesehen, dass als gut leitendes Material Titan und/oder Wolfram und/oder Aluminium und/oder Tantal und/oder Kupfer und/oder Platin und/oder Gold und/oder eine Kombination derselben verwendet wird.

Ein weiterer Aspekt der Erfindung betrifft die Herstellung von elektrischen Verbindungen zwischen einzelnen auf bzw. in einem Halbleiter-Substrat ausgebildeten Schaltungselementen, mit den Verfahrensschritten:
- Herstellen der einzelnen, zu verbindenden Schaltungselementen in bzw. auf dem Halbleitersubstrat,
- Planarisieren der Schaltungselemente auf bzw. in dem Halbleitersubstrat durch Auffüllen von Vertiefungen und Unebenheiten mit einem Füllmaterial,
- Fertigen von Leiterbahnkanälen in die planarisierte Fläche aus Schaltungselementen und Füllmaterial hinein, und
- Auffüllen der Leiterbahnkanäle mit einem gut leitenden Material.

Nach dem Auffüllen der Leiterbahnkanäle mit dem gut leitenden Material wird nach einem vorteilhaften und daher bevorzugten Verfahrensschritt das unter den Leiterbahnkanälen liegende Halbleitermaterial mit dem leitenden Material durch eine Temperierung ("annealing") silizidiert. Hierdurch wird die Kontaktierung des leitenden Materials mit dem Halbleitermaterial verbessert.

Ein ebenso vorteilhafter Verfahrensschritt sieht vor, dass vor dem Auffüllen der Leiterbahnkanäle mit dem gut leitenden Material auf dem unter den Leiterbahnkanälen liegendem Halbleitermaterial und/oder den Seitenflächen der Seitenflächenisolation und/oder den Seitenflächen der Elektroden-Substrat-Kontaktierung eine oder mehrere Schichten zur besseren Kontaktierung aufgebracht wird. Dem folgend bestehen die Schichten zur Verbesserung der Kontaktierung aus einer Kontaktschicht und/oder einer Barrierenschicht zur Verhinderung von Metalldiffusion in das Halbleitermaterial.

Die Erfindung betrifft weiterhin ein Halbleiterbauelement mit einem Substrat und wenigstens einem Elektrodenanschluss, der elektrisch mit dem Substrat verbunden ist, wobei der Elektrodenanschluss mit dem Substrat durch auf das Substrat aufgewachsenes Halbleitermaterial kontaktiert ist.

Eine bevorzugte Ausgestaltung der Erfindung sieht vor, dass der mit dem Substrat über das aufgewachsene Halbleitermaterial kontaktierte Elektrodenanschluss vollständig auf einer auf dem Substrat befindlichen Isolationssicht ausgebildet ist.

Eine besonders vorteilhafte und daher bevorzugte Ausgestaltung der Erfindung sieht vor, dass in dem Substrat unter dem aufgewachsenen Halbleitermaterial ein dotierter Bereich und/oder ein dotierter Kontakt-Bereich liegt. Hierdurch wird die Herstellung von Dioden oder Transistoren mit guter elektrischer Kontaktierung ermöglicht.

Weitere Ausgestaltungen sehen weitere Elektrodenanschlüsse vor, die ebenfalls auf der Isolierungsschicht ausgebildet sind und zum Teil mit dem Substrat kontaktiert sind. Dem folgend ist nach einer bevorzugten Ausgestaltung das Halbleiter-bauelement ein Feldeffekttransistor.

Vorteilhafterweise ist das Halbleitermaterial monolithisch oder polykristallin aufgewachsen.

Auf dem ersten und/oder dem zweiten und/oder dem dritten Elektrodenanschluss ist nach einer weiteren bevorzugten Ausgestaltung der Erfindung ein gut leitendes Material aufgebracht. Hierdurch können die Kontakteigenschaften der Elektrodenanschlüsse zu gewünschten Eigenschaften hin verändert werden.

Vermittels des gut leitenden Materials werden ebenso vorteilhaft verschiedene auf dem gleichen Substrat ausgebildete Halbleiterbauelemente miteinander elektrisch verbunden. Hierdurch sind im selben Prozessschritt die elektrischen Verbindungen zwischen den einzelnen Bauelementen herstellbar. Wiederum werden sonst eigens hierzu notwendige Masken und Prozessschritte eingespart.

Weitere Vorteile, Besonderheiten und zweckmäßige Weiterbildungen der Erfindung ergeben sich aus den weiteren Unteransprüchen.

Nachfolgend wird die Erfindung anhand der Zeichnung weiter erläutert. Im Einzelnen zeigen die schematischen Darstellungen in:
- Figur 1: eine schematische Querschnittsdarstellung durch ein Substrat mit flachen Grabenisolationen und darauf aufgebrachten Schichten;
- Figur 2: eine schematische Querschnittsdarstellung durch ein Substrat mit darauf aufgebrachten Schichten;
- Figur 3: eine schematische Querschnittsdarstellung durch ein Substrat mit darauf aufgebrachten Schichten und einer Deckschicht;
- Figur 4: eine schematische Querschnittsdarstellung durch ein Substrat mit darauf aufgebrachten Elektrodenanschlüssen die aus den Schichten durch einen Strukturierungsschritt gefertigt wurden;
- Figur 5: eine schematische Querschnittsdarstellung durch ein Substrat mit darauf aufgebrachten Elektrodenanschlüssen mit Seitenisolierungsschichten;
- Figur 6a: eine schematische Querschnittsdarstellung durch ein Substrat mit darauf aufgebrachten Elektrodenanschlüssen und dotierten Bereichen;
- Figur 6b: eine schematische Querschnittsdarstellung durch ein Substrat mit darauf aufgebrachten Elektrodenanschlüssen und einer Abdeckschicht;
- Figur 7: eine schematische Querschnittsdarstellung durch ein Substrat mit darauf aufgebrachten Elektrodenanschlüssen und Auffüllungen mit Ausnehmungen zwischen den Elektrodenanschlüssen;
- Figur 8: eine schematische Querschnittsdarstellung durch ein Substrat mit darauf aufgebrachten Elektrodenanschlüssen und gefertigten Elektroden-Substrat-Kontaktierungen;
- Figur 9: eine schematische Querschnittsdarstellung durch ein Substrat mit darauf aufgebrachten Elektrodenanschlüssen und gefertigten Elektroden-Substrat-Kontaktierungen bei einem Dotierungsprozess;
- Figur 10: eine schematische Querschnittsdarstellung durch ein Substrat mit darauf aufgebrachten Elektrodenanschlüssen und gefertigten Elektroden-Substrat-Kontaktierungen und dotierten Kontakt-Bereichen;
- Figur 11: eine schematische Querschnittsdarstellung durch ein Substrat mit darauf aufgebrachten, planarisierten Elektrodenanschlüssen;
- Figur 12: eine schematische Querschnittsdarstellung durch ein Substrat mit darauf aufgebrachten Elektrodenanschlüssen und in die planarisierte Oberfläche hinein gearbeiteten Vertiefungen;
- Figur 13: eine schematische Querschnittsdarstellung durch ein Substrat mit darauf aufgebrachten Elektrodenanschlüssen und mit einer Leiterschicht ausgefüllten Vertiefungen;
- Figur 14: eine schematische Querschnittsdarstellung durch ein Substrat mit darauf aufgebrachten, planarisierten Elektrodenanschlüssen mit einer Leiterschicht; und
- Figur 15: eine schematische Querschnittsdarstellung durch ein Substrat mit darauf ausgebildeten integrierten Bauelementen.

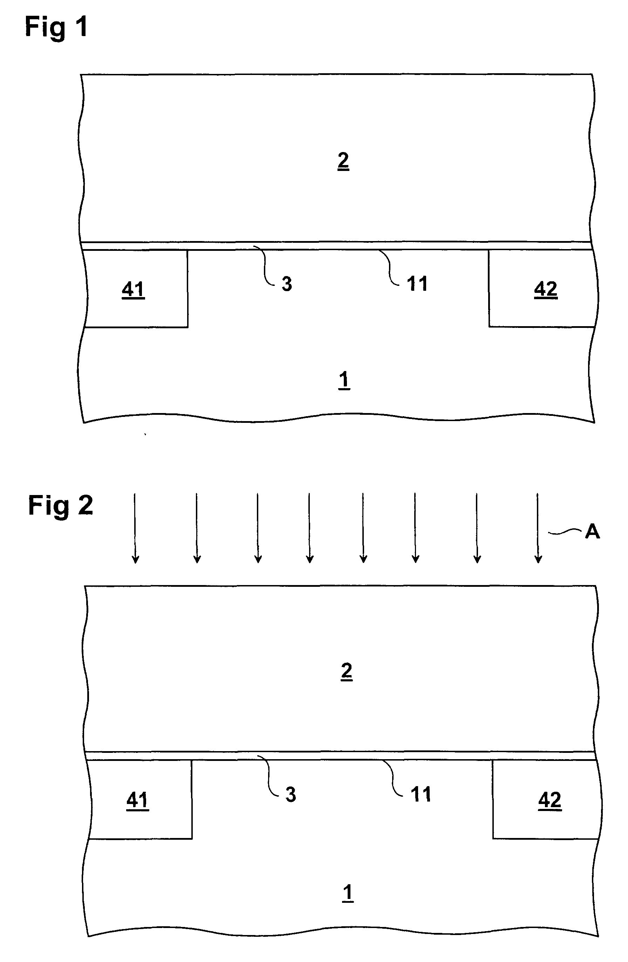

In den Figuren 1 bis 14 ist das erfindungsgemäße Verfahren zur Herstellung eines erfindungsgemäßen integrierten Bauelementes dargestellt. Die Bezeichnungen der Figuren 1 bis 15 gelten hierbei für gleiche oder gleich wirkende Teile analog.

Figur 1 zeigt ein Halbleitersubstrat 1 mit darin bereits hergestellten flachen Grabenisolationen ("shallow-trench isolation") 41 und 42 und mit einer auf diesen und auf der Hauptoberfläche 11 des Halbleitersubstrats 1 ausgebildeten Isolationsschicht 3. Die Isolationsschicht 3 wird hierbei durch eine dünne (Gate-)Oxidschicht gebildet. Die flachen Grabenisolationen sind hierbei nicht in jedem Fall erforderlich; sie werden anstelle des sonst üblichen Feldoxids verwendet. Auf die Isolationsschicht 3 wird die Elektrodenanschluss-Schicht 2 aufgebracht. Vorzugsweise wird die Elektrodenanschluss-Schicht durch eine Polysiliziumschicht gebildet.

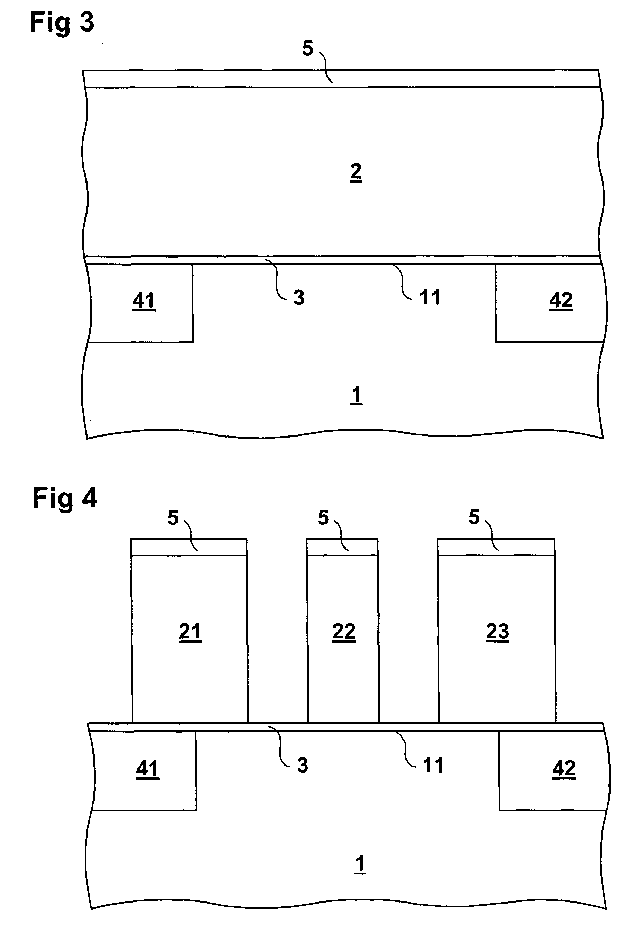

Da in den weiteren Prozeßschritten aus der Elektrodenanschluss-Schicht 2 die Elektrodenanschlüsse gefertigt werden, muss die Polysiliziumschicht bereits in situ hochdotiert sein oder nach deren Aufbringen in einem weiteren Schritt, wie in Figur 2 dargestellt vermittels einer Diffusion A von geeignetem Dotierungsmaterial dotiert werden. Anschließend hieran wird wie in Figur 3 dargestellt eine Deckschicht 5 aufgebracht, die beispielsweise aus einer Nitritverbindung bestehen kann. Die Nitritschicht wird dann in herkömmlicher Weise beispielsweise vermittels Lithographieverfahren mit Masken (Retikeln) und Lacken strukturiert. Aus der Elektrodenanschluss-Schicht 2 werden in einem hierauf durchgeführten Ätzschritt die nicht durch die Deckschicht geschützten Bereiche herausgeätzt, so dass die Elektrodenanschlüsse 21, 22 und 23 auf der Oxidschicht 3 strukturiert werden (Figur 4). Als Ätzmaterial wird vorzugsweise eine Substanz verwendet, die lediglich die Elektrodenanschluss-Schicht, nicht aber die Isolierungsschicht 3 abträgt.

Nach dem erfindungsgemäßen Verfahren werden also die Source-, Gate- und Drain-Elektrodenanschlüsse 21 bis 23 gleichzeitig hergestellt. Hierdurch erhält man gleich hohe Anschlüsse die in ihren elektrischen und/oder ihren geometrischen Eigenschaften sehr ähnlich sind. Selbstjustierende Strukturierung ist somit ermöglicht.

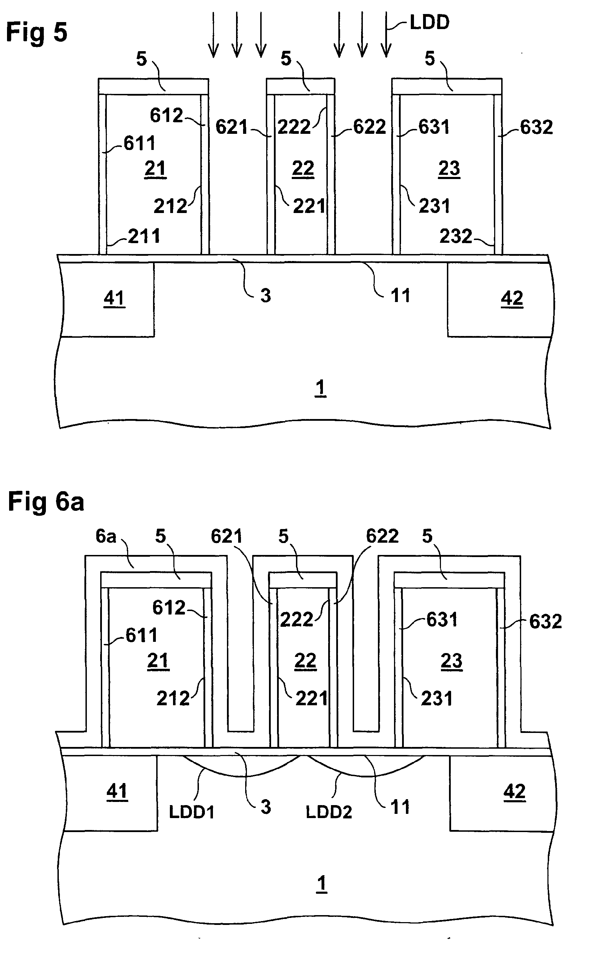

In einem weiteren Schritt werden wie in Figur 5 dargestellt die Seitenflächen 211 bis 232 durch eine oberflächliche Oxidation der Elektrodenanschlüsse mit Seitenisolationsschichten 611 bis 632 überzogen. Hierdurch werden in den weiteren Prozeßschritten die Elektrodenanschlüsse vor ungewollten Reaktionen mit den weiteren eingesetzten Materialien und Substanzen geschützt.

Nach Figur 5 werden weiterhin zur Herstellung der für einen Feldeffekttransistor notwendigen dotierten Bereiche LDD1 und LDD2 im Halbleitersubstrat 1 die Dotierstoffe durch Implantation LDD und in einem Temperierungsprozess ("annealing") in das Halbleitersubstrat 1 hinein diffundiert (durch die Isolationsschicht 3 hindurch), wodurch die in Figur 6a dargestellten dotierten Bereiche LDD1 und LDD2 unter den nicht mehr durch die Elektrodenanschluss-Schicht 2 bedeckten Bereichen im Substrat 1 entstehen. In Figur 6a ist bereits der nächste Schritt vollzogen, bei dem die Strukturen auf dem Substrat mit einer Oxidschicht 6a überzogen werden.

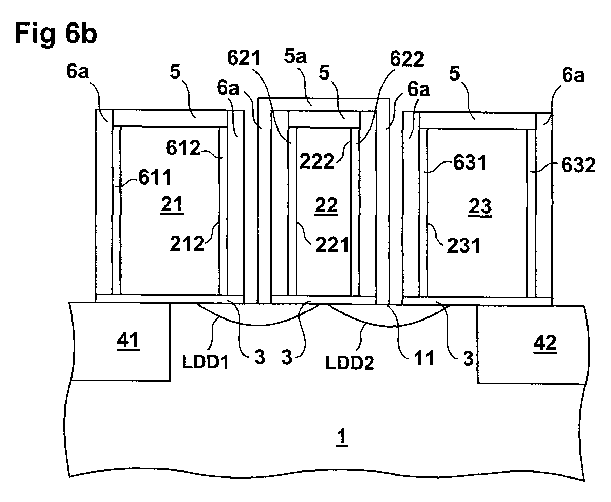

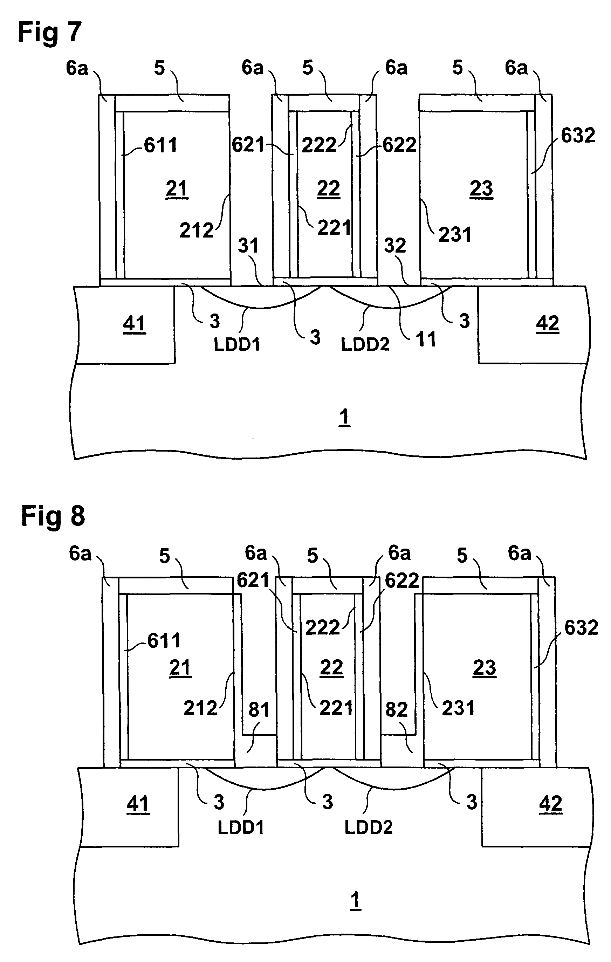

In dem nächsten Strukturierungsschritt nach Figur 6b werden Teile der Oxidschicht 6a sowie der darunter liegenden Isolierungsschicht 3 zwischen den Elektroden 21 bis 23 weggenommen, wodurch eine das Substrat 1 freilegende Ausnehmung in der Isolationsschicht entsteht (siehe auch Figur 7). Zur Strukturierung des Oxids wird wieder ein herkömmliches Photolithographieverfahren verwendet. Figur 6b zeigt weiterhin den nächsten Herstellungs-Schritt. Die mittlere (Gate-) Elektrodenstruktur wird zusätzlich noch mit einer Abdeckschicht 5a zu deren Schutz überzogen.

Figur 7 zeigt die Struktur nach einer isotropen Oxidätzung, nach der die das Substrat 1 freilegende Ausnehmung 31 und 32 in der Isolationsschicht ihre endgültige Form erhält (weiteres Entfernen von der Isolationsschicht 3) und die Seitenflächen 212 und 231 des ersten 21 und dritten 23 Elektrodenanschlusses (Source und Drain) freigelegt werden.

Auf das freigelegte Substrat 1 in den Ausnehmungen 31 und 32 und auf die freigelegten Seitenflächen 212 und 231 des ersten 21 und dritten 23 Elektrodenanschlusses (Source und Drain) wird nun in einem weiteren Verfahrensschritt, wie in Figur 8 dargestellt, eine Elektroden-Substrat-Kontaktierung 81 und 82 aus Halbleitermaterial aufgewachsen. Hierbei kann wiederum Polysilizium zum Einsatz kommen oder monolithisch gewachsenes Halbleitermaterial epitaktisch aufgebracht werden. Bei der Verwendung von Polysilizium kann das Material wiederum in situ dotiert sein, oder nachträglich implantiert werden.

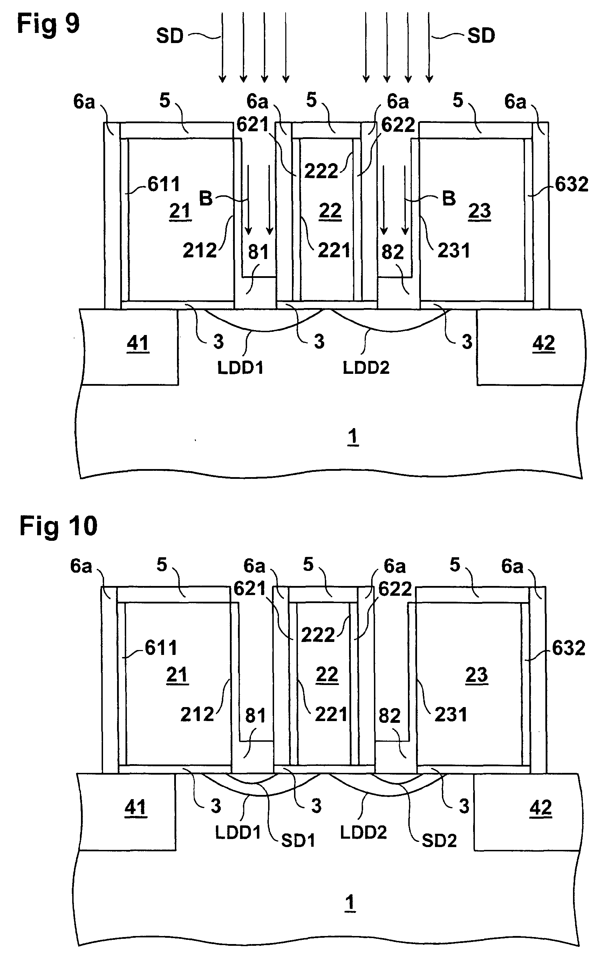

Im Falle dass epitaktisch gewachsenes Material verwendet wird, kann eine in Figur 9 dargestellte Dotierung durch Implantation SD und einen anschließenden Temperierungsprozess ("annealing") von Dotierungsmaterial SD vorgenommen werden. Die so dotierten Gebiete dienen zusammen mit 21 und 23 als Source/Drain Anschlüsse eines Feldeffekttransistors.

Zur Verbesserung der Kontakteigenschaften wird gemäß Figur 10 aus den Elektroden-Substrat-Kontaktierungen 81 und 82 in die dotierten Bereiche LDD1 und LDD2 des Substrats jeweils ein dotierter Kontakt-Bereich SD1 und SD2 hinein eingebracht. Dies kann wieder durch einen Temperierungsprozess ("annealing") geschehen.

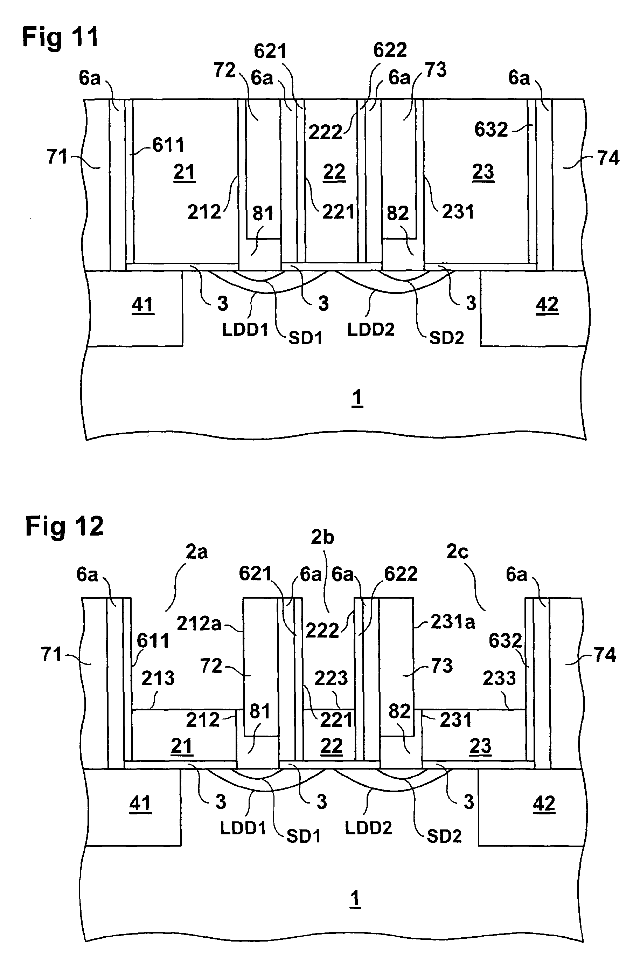

Zur Planarisierung der Oberfläche werden die restlichen Unebenheiten und Vertiefungen zwischen den Elektrodenanschlüssen mit Auffüllungen 71 bis 74 aufgefüllt (Figur 11). Die Oberfläche kann hierbei vermittels eines chemisch-mechanischen Polierprozesses geglättet werden.

Da in diesem Stadium die auf und in dem Halbleitersubstrat 1 aufgebrachte Struktur völlig planarisiert ist, kann ein standardmäßiger Silizidationsprozess zur Herstellung der Kontakte bzw. der Leiterbahnen ohne Weiteres durchgeführt werden. Das hierzu notwendige Metall könnte einfach abgeschieden werden und in einem geeigneten Temperierungsprozess ("annealing") die Silizidation auf den Elektrodenanschlüssen 21, 22 und 23 hervorrufen. Das übriggebliebene, nicht mit dem Halbleitermaterial reagierte Metall könnte danach in einem geeigneten Ätzprozess leicht entfernt werden.

Ein weiterer Ansatz zur Herstellung der Kontakte bzw. der Leiterbahnen ist in Figur 12 dargestellt. Hierbei werden zunächst vermittels eines geeigneten Ätzprozesses, beispielsweise eines reaktiven Ionen-Ätzprozesses die aus Polysilizium bestehenden Elektrodenanschlüsse 21 bis 23 bis zu einer vorbestimmten Höhe abgetragen. Für den reaktiven Ionen-Ätzprozess kann hierbei eine Ätzgas-Mischung auf Brombasis Verwendung finden, da so eine gute Selektivität des Ätzprozesses bezüglich der Elektrodenanschlüsse erfolgt.

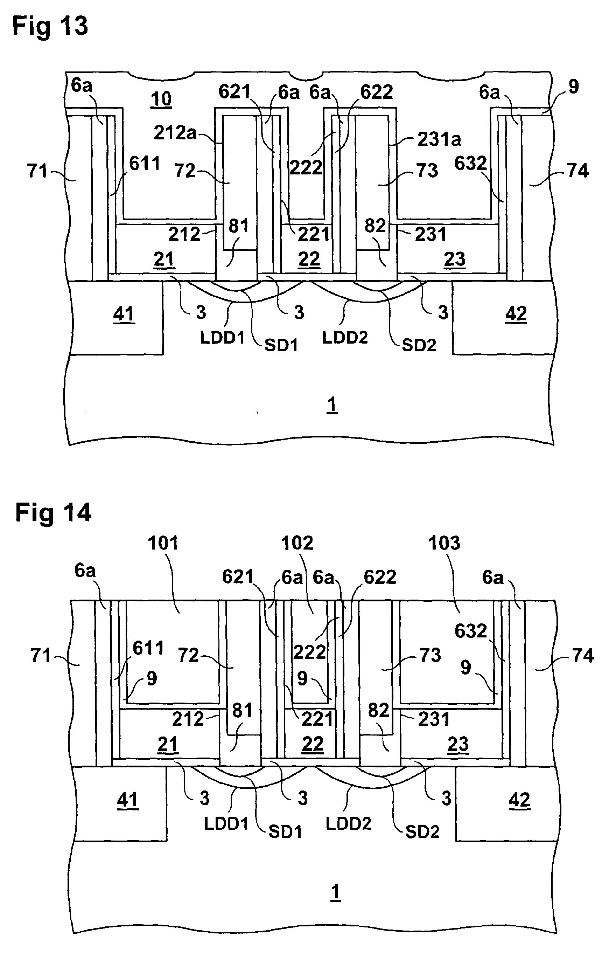

Nach geeigneter Säuberung der Oberflächen wird eine dünne Kontaktschicht 9, beispielsweise aus einer Titan-Nitrit-Schicht abgeschieden und wie in Figur 13 dargestellt mit einer Leiterschicht 10 überzogen. Die Leiterschicht 10 kann hierbei geeigneterweise aus Wolfram bestehen und füllt die durch die Abtragung der Elektrodenanschlüsse 21 bis 23 entstandenen Leiterbahnkanäle 2a bis 2c.

Figur 14 zeigt das Ergebnis eines weiteren Planarisierungsprozesses, bevorzugterweise wiederum eines chemisch-mechanischen Polierprozesses, wodurch die Oberfläche 111 der Struktur geglättet wird. Die aufgebrachte Metallschicht (10, 101 bis 103) wird hierzu bis auf Höhe der Auffüllungen 71 bis 74 abgetragen. Somit entsteht eine sehr gut leitende Leiterbahnschicht aus Metall in der Struktur, wobei die Oberfläche 111 einheitlich und eben ist.

Für den chemisch-mechanischen Polierprozess wird vorzugsweise eine Wasserstoffperoxydlösung verwendet, da diese vorteilhafter Weise keine unerwünschten Verunreinigungen (Elemente) enthält wie beispielsweise in den sonst standardmäßig verwendeten Eisen-Nitrat-Lösungen. Deren Eisenbestandteile diffundieren in Form von Eisenionen unerwünschter Weise in das kristalline Silizium (Substrat, Anschlüsse) ein und wirken dort als störende Rekombinationszentren.

Die nach dem Verfahren der Erfindung schließlich gewonnene völlig planarisierte Oberfläche der Struktur kann nun wiederum leicht zur Ausbildung von weiteren Schichten verwendet werden. Anders als bisher üblich sind so in einfacher Weise Multi-Layer-Strukturen herzustellen bzw. erstmals ermöglicht.

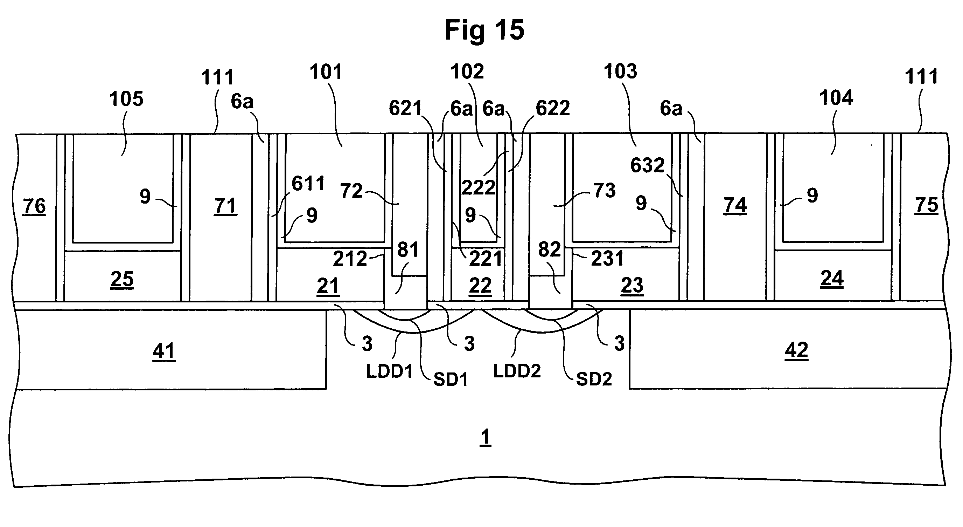

In Figur 15 ist nochmals ein Querschnitt durch eine auf einem Halbleitersubstrat 1 aufgebrachte Struktur gezeigt, wobei zusätzlich noch einzelne Bauelemente verbindende Leiterbahnen 104 und 105 dargestellt sind, die ihrerseits wiederum auf der Elektrodenanschluss-Schicht 24 und 25 ausgebildet sind und deren Zwischenräume mit weiteren Auffüllungen 75 und 76 ausgefüllt sind. Zur Reduzierung störender Kapazitäten sind diese auch vollständig auf flachen Grabenisolationen 41 und 42 ausgebildet.

## Patentansprüche

1. Verfahren zur Herstellung eines auf einem Halbleiter-Substrat (1) ausgebildeten integrierten Bauelements mit wenigstens einem gegenüber der Hauptoberfläche (11) des Substrats aufragend ausgebildeten Elektrodenanschluss (21), mit den Verfahrensschritten:
- Ausbilden einer Isolationsschicht (3) auf der Hauptoberfläche (11) des Halbleiter-Substrats (1),
- Ausbilden des erhöhten, gegenüber der Hauptoberfläche (11) aufragenden Elektrodenanschlusses (21) auf der Isolationsschicht (3),
- Fertigen einer das Halbleiter-Substrat (1) freilegenden Ausnehmung (31) in der Isolationsschicht (3) durch wenigstens teilweises Entfernen der Isolationsschicht (3), wobei die Ausnehmung (31) an der Seitenfläche (211) des Elektrodenanschlusses (21) abschließt, und
- Aufwachsen einer Elektroden-Substrat-Kontaktierung (81) direkt auf dem Halbleiter-Substrat (1) in der Ausnehmung (31) der Isolationsschicht (3), wobei die Elektroden-Substrat-Kontaktierung (81) in elektrisch leitendem Kontakt mit dem zweiten Elektrodenanschluss (21) steht.

2. Verfahren nach Anspruch 1,
**dadurch gekennzeichnet,**
**dass** die Elektroden-Substrat-Kontaktierung (81) monolithisch aufgewachsen wird.

3. Verfahren nach Anspruch 1,
**dadurch gekennzeichnet,**
**dass** die Elektroden-Substrat-Kontaktierung (81) polykristallin aufgewachsen wird.

4. Verfahren nach einem der Ansprüche 1 bis 3,
**dadurch gekennzeichnet,**
**dass** vor der Herstellung der Elektroden-Substrat-Kontaktierung (81) auf dem Halbleiter-Substrat (1) ein unterhalb der Ausnehmung und/oder der nachher herzustellenden Elektroden-Substrat-Kontaktierung (81) und innerhalb des Halbleiter-Substrats (1) liegender dotierter Bereich (LDD1) ausgebildet wird.

5. Verfahren nach Anspruch 4,
**dadurch gekennzeichnet,**
**dass** der dotierter Bereich (LDD1) durch eine Diffusion eines Dotierungsmaterials aus oder durch die Isolationsschicht (3) in das Halbleiter-Substrat (1) hinein hergestellt wird.

6. Verfahren nach einem der Ansprüche 1 bis 5,
**dadurch gekennzeichnet,**
**dass** nach der Herstellung der Elektroden-Substrat-Kontaktierung (81) auf dem Halbleiter-Substrat (1) ein unterhalb der Elektroden-Substrat-Kontaktierung (81) und innerhalb des Halbleiter-Substrats (1), insbesondere innerhalb des dotierten Bereichs (LDD1) liegender dotierter Kontakt-Bereich (SD1) ausgebildet wird.

7. Verfahren nach Anspruch 6,
**dadurch gekennzeichnet,**
**dass** der dotierte Kotakt-Bereich (SD1) durch eine Diffusion eines im Material der Elektroden-Substrat-Kontaktierung (81) enthaltenen oder in dieses nachträglich eindiffundiertes Dotierungsmaterials in das Halbleiter-Substrat (1) hinein hergestellt wird.

8. Verfahren nach einem der Ansprüche 1 bis 7,
**dadurch gekennzeichnet,**
**dass** wenigstens ein erster und ein zweiter Elektrodenanschluss (21 und 22) auf der Isolationsschicht (3) hergestellt werden und die Ausnehmung (31) in der Isolationsschicht (3) zwischen den beiden Elektrodenanschlüssen (22 und 21) hergestellt wird.

9. Verfahren nach Anspruch 8,
**dadurch gekennzeichnet,**
**dass** die Elektroden-Substrat-Kontaktierung (81) so aufgewachsen wird, dass sie nur in elektrischem Kontakt mit dem ersten Elektrodenanschluss (21) steht.

10. Verfahren nach Anspruch 8 oder 9,
**dadurch gekennzeichnet,**
**dass** vor dem Aufwachsen der Elektroden-Substrat-Kontaktierung (81) eine Seitenisolierungsschicht (621) an der dem ersten Elektrodenanschluss (21) zugewandten Seitenfläche (221) des zweiten Elektrodenanschlusses (22) zur Vermeidung eines elektrischen Kontakts bzw. einer elektrischen Verbindung zwischen der Elektroden-Substrat-Kontaktierung (81) und des zweiten Elektrodenanschlusses (22) ausbildet wird.

11. Verfahren nach einem der Ansprüche 1 bis 10,
**dadurch gekennzeichnet,**
**dass** wenigstens drei erhöhte, gegenüber der Hauptoberfläche (11) aufragende Elektrodenanschlüsse (21, 22 und 23) auf der Isolationsschicht (3) ausbildet werden.

12. Verfahren nach Anspruch 11,
**dadurch gekennzeichnet,**
**dass** zwischen jeweils zwei der drei Elektrodenanschlüsse (21, 22 und 23) jeweils eine Ausnehmung (31 und 32) in der Isolationsschicht (3) und jeweils ein dotierter Bereich (LDD1 und LDD2) und/oder jeweils ein dotierter Kontakt-Bereich (SD1 und SD2) unter jeweils einer Elektroden-Substrat-Kontaktierung (81 und 82) im Halbleiter-Substrat (1) hergestellt werden.

13. Verfahren nach Anspruch 1 bis 12,
**dadurch gekennzeichnet,**
**dass** als integriertes Bauelement ein Feldeffekttransistor hergestellt wird.

14. Verfahren nach Anspruch 1 bis 13,
**dadurch gekennzeichnet,**
**dass** die Elektroden-Substrat-Kontaktierung (81) dergestalt hergestellt wird, dass die gegenüber der Hauptoberfläche (11) des Halbleiter-Substrats (1) horizontale Ausdehnung der Elektroden-Substrat-Kontaktierung (81) kleiner als die gegenüber der Hauptoberfläche des Halbleiter-Substrats horizontale Ausdehnung des Elektrodenanschlusses (21 oder 22) ist.

15. Verfahren nach einem der Ansprüche 1 bis 14,
**dadurch gekennzeichnet,**
**dass** die Elektroden-Substrat-Kontaktierung (81) so hergestellt wird, dass ihre gegenüber dem Halbleiter-Substrat (1) vertikale Ausdehnung unter der gegenüber dem Halbleiter-Substrat vertikalen Ausdehnung des Elektrodenanschlusses (21 oder 22) liegt.

16. Verfahren nach einem der Ansprüche 1 bis 15,
**dadurch gekennzeichnet,**
**dass** wenigstens einer der Elektrodenanschlüsse (21, 23) teilweise über einer in dem Halbleiter-Substrat (1) ausgebildeten flachen Grabenisolation (4) ("shallow-trench isolation") ausgebildet wird.

17. Verfahren nach einem der Ansprüche 1 bis 16,
**dadurch gekennzeichnet,**
**dass** auf dem Substrat (1) bzw. der Isolationsschicht (3) oder der Elektroden-Substrat-Kontaktierung (81, 82) eine Auffüllung (71 bis 74, 6a) aufgebracht wird, die die Seitenflächen (211 bis 232) bzw. die Seitenflächenisolationsschichten (611 bis 632) wenigstens eines Elektrodenanschlusses (21 bis 23) bedecken.

18. Verfahren nach einem der Ansprüche 1 bis 17,
**dadurch gekennzeichnet,**
**dass** wenigstens einer der Elektrodenanschlüsse (21, 22, 23) bis zu einer vorbestimmten Höhe abgetragen wird.

19. Verfahren nach Anspruch 18,
**dadurch gekennzeichnet,**
**dass** die sich durch das Abtragen des Elektrodenanschlusses (21, 22, 23) zwischen den vormals diesen angrenzenden Auffüllungen (71 bis 74, 6a) und/oder den Seitenflächenisolationsschichten (611 bis 632) gebildete Vertiefung (2a bis 2c) mit einer Leiterschicht (101 bis 103, 10) aus einem gut leitenden Material (10) ausgefüllt wird.

20. Verfahren nach einem der Ansprüche 19,
**dadurch gekennzeichnet,**
**dass** nach dem Auffüllen der Vertiefung (2a, 2b, 2c) mit dem gut leitenden Material (10) durch eine Temperierung eine Silizidierung des gut leitenden Materials (10, 101 bis 103) mit dem darunter liegendem Elektrodenanschluss (2, 21, 22, 23) und/oder der Elektroden-Substrat-Kontaktierung hergestellt wird.

21. Verfahren nach Anspruch 19 oder 20,
**dadurch gekennzeichnet,**
**dass** vor dem Ausfüllen mit dem gut leitenden Material (10, 102 bis 103) die die Vertiefung (2a, 2b, 2c) bildende, von der Hauptoberfläche (11) des Substrats (1) abgewandte Seitenfläche (213, 223, 233) des Elektrodenanschlusses (21, 22, 23) und/oder die der Vertiefung zugewandten Seitenflächen der Auffüllung (71 bis 74, 6a) oder der Seitenflächenisolationsschichten (611 bis 632) mit einer Kontaktschicht bedeckt werden.

22. Verfahren nach einem der Ansprüche 19 bis 21,
**dadurch gekennzeichnet,**
**dass** die Auffüllung(en) mit dem gut leitenden Material eine Leiterbahnschicht (101, 102, 103) ("local interconnect system") bildet, mit der einzelne integrierte auf bzw. in dem Halbleiter-Substrat (1) ausgebildete Bauelemente miteinander verbunden werden.

23. Verfahren nach einem der Ansprüche 1 bis 22,
**dadurch gekennzeichnet,**
**dass** die Oberfläche (111) der auf dem Substrat (1) ausgebildeten integrierten Bauelements bzw. Bauelementen und der Auffüllungen (71 bis 74, 6a) vermittels eines chemisch-mechanischen Polierprozesses poliert wird.

24. Verfahren nach Anspruch 23,
**dadurch gekennzeichnet,**
**dass** für den chemisch-mechanischen Polierprozesses ein Wasserstoffperoxyd enthaltendendes Schleif/Poliermittel verwendet wird.

25. Verfahren nach einem der Ansprüche 17 bis 24,
**dadurch gekennzeichnet,**
**dass** für die Auffüllungen (71 bis 74, 6a) Oxid und/oder Bor-Phosphor-Silikatglas verwendet wird.

26. Verfahren nach einem der Ansprüche 19 bis 25,
**dadurch gekennzeichnet,**
**dass** als gut leitendes Material (10, 101, 102, 103) Titan und/oder Wolfram und/oder Aluminium und/oder Tantal und/oder Kupfer und/oder Platin und/oder Gold und/oder eine Kombination derselben verwendet wird.

27. Verfahren zur Herstellung von elektrischen Verbindungen (101, 102, 103, 10) zwischen einzelnen auf bzw. in einem Halbleiter-Substrat (1) ausgebildeten Schaltungselementen (21, 22, 23, LDD1, LDD2, SD1, SD2, 81, 82),
**gekennzeichnet durch** die Verfahrensschritte:
- Herstellen der einzelnen, zu verbindenden Schaltungselemente in (LDD1, LDD2, SD1, SD2) bzw. auf (21, 22, 23, 81, 82) dem Halbleitersubstrat (1),
- Planarisieren der Schaltungselemente auf bzw. in dem Halbleitersubstrat (1) durch Auffüllen von Vertiefungen und Unebenheiten mit einem Füllmaterial (71 bis 74, 6a),
- Fertigen von Leiterbahnkanälen (2a, 2b, 2c) in die planarisierte Fläche (111) aus Schaltungselementen und Füllmaterial (21, 22, 23, 81, 82, 71 bis 74, 6a) hinein, und
- Auffüllen der Leiterbahnkanäle (2a, 2b, 2c) mit einem gut leitenden Material (10).

28. Verfahren nach Anspruch 27,
**dadurch gekennzeichnet,**
**dass** nach dem Auffüllen der Leiterbahnkanäle (2a, 2b, 2c) mit dem gut leitenden Material (10) das unter den Leiterbahnkanälen (2a, 2b, 2c) liegende Halbleitermaterial (2, 21, 22, 23, 81, 82) mit dem leitenden Material (10, 101, 102, 103) durch eine Temperierung ("annealing") silizidiert wird.

29. Verfahren nach Anspruch 27 oder 28,
**dadurch gekennzeichnet,**
**dass** vor dem Auffüllen der Leiterbahnkanäle (2a, 2b, 2c) mit dem gut leitenden Material (10) auf dem unter den Leiterbahnkanälen liegendem Halbleitermaterial (2, 21 bis 23, 81, 82) und/oder den Seitenflächen der Seitenflächenisolation (611, 621, 622, 632) und/oder den Seitenflächen der Elektroden-Substrat-Kontaktierung (81, 82) eine oder mehrere Schichten (9) zur besseren Kontaktierung aufgebracht werden.

30. Verfahren nach Anspruch 29,
**dadurch gekennzeichnet,**
**dass** die Schichten zur Verbesserung der Kontaktierung aus einer Kontaktschicht und/oder einer Barrierenschicht zur Verhinderung von Metalldiffusion in das Halbleitermaterial (2) bestehen.

31. Halbleiterbauelement mit einem Substrat und wenigstens einem Elektrodenanschluss (21), der elektrisch mit dem Substrat (1) verbunden ist,
**dadurch gekennzeichnet,**
**dass** der Elektrodenanschluss (21) mit dem Substrat (1) durch auf das Substrat aufgewachsenes Halbleitermaterial (81) kontaktiert ist.

32. Halbleiterbauelement nach Anspruch 31,
**dadurch gekennzeichnet,**
**dass** der Elektrodenanschluss (21) vollständig auf einer auf dem Substrat (1) befindlichen Isolationssicht (3) ausgebildet ist.

33. Halbleiterbauelement nach Anspruch 31 oder 32,
**dadurch gekennzeichnet,**
**dass** in dem Substrat (1) unter dem aufgewachsenen Halbleitermaterial (81) ein dotierter Bereich (LDD1) und/oder ein dotierter Kontakt-Bereich (SD1) liegt.

34. Halbleiterbauelement nach einem der Ansprüche 31 bis 33,
**dadurch gekennzeichnet,**
**dass** ein zweiter Elektrodenanschluss (22) vorgesehen ist, der vom Substrat (1) elektrisch isoliert ist und ebenfalls auf der Isolationssicht (3) ausgebildet ist.

35. Halbleiterbauelement nach einem der Ansprüche 31 bis 34,
**dadurch gekennzeichnet,**
**dass** ein dritter Elektrodenanschluss (23) vorgesehen ist, der mit dem Substrat (1) durch auf das Substrat aufgewachsenes Halbleitermaterial (82) kontaktiert ist.

36. Halbleiterbauelement nach Anspruch 35,
**dadurch gekennzeichnet,**
**dass** in dem Substrat (1) unter dem aufgewachsenen Halbleitermaterial (82) ein zweiter dotierter Bereich (LDD2) und/oder ein zweiter dotierter Kontakt-Bereich (SD2) liegt.

37. Halbleiterbauelement nach einem der Ansprüche 31 bis 36,
**dadurch gekennzeichnet,**
**dass** das Halbleitermaterial (81, 82) monolithisch oder polykristallin aufgewachsen ist.

38. Halbleiterbauelement nach einem der Ansprüche 31 bis 37,
**dadurch gekennzeichnet,**
**dass** das Halbleiterbauelement ein Feldeffekttransistor ist.

39. Halbleiterbauelement nach einem der Ansprüche 31 bis 38,
**dadurch gekennzeichnet,**
**dass** auf dem ersten (21) und/oder dem zweiten (22) und/oder dem dritten (23) Elektrodenanschluss ein gut leitendes Material (10, 101, 102, 103) aufgebracht ist.

40. Halbleiterbauelement nach Anspruch 39,
**dadurch gekennzeichnet,**
**dass** vermittels des gut leitenden Materials (10, 101, 102, 103) verschiedene auf dem gleichen Substrat (1) ausgebildete Halbleiterbauelemente miteinander elektrisch verbunden sind.

41. Halbleiterbauelement nach einem der Ansprüche 39 bis 40,
**dadurch gekennzeichnet,**
**dass** gut leitendes Material (10, 101, 102, 103) wenigstens teilweise aus Titan und/oder aus Wolfram und/oder aus Aluminium und/oder aus Tantal und/oder aus Kupfer und/oder Platin und/oder Gold besteht.
